# FASCICULE DE BREVET EUROPEEN

(11) **EP 0 827 640 B1**
(45) Date de publication et mention de la délivrance du brevet: **24.03.1999**
(21) Numéro de dépôt: 96917539.7
(22) Date de dépôt: 23.05.1996
(51) Int. Cl.: H01S 3/085, H01S 3/103, H04B 10/155

(54) **PROCEDE ET DISPOSITIFS D'EMISSION OU RECEPTION LASER POUR LA TRANSMISSION D'INFORMATIONS PAR VOIE OPTIQUE**
VERFAHREN UND LASERVORRICHTUNG ZUR OPTISCHEN NACHRICHTEN-ÜBERTRAGUNG
LASER TRANSMITTING OR RECEIVING DEVICES AND METHOD, FOR OPTICALLY TRANSMITTING INFORMATION

(30) Priorité: 23.05.1995 FR 9506104
(43) Date de publication de la demande: 11.03.1998
(73) Titulaire: Labeyrie, Antoine, 04870 Saint-Michel-de-l'Observatoire (FR)
(72) Inventeur: Labeyrie, Antoine, 04870 Saint-Michel-de-l'Observatoire (FR)
(74) Mandataire: Thibon-Littaye, Annick
(86) Numéro de dépôt international: FR9600775
(87) Numéro de publication internationale: WO9637933

(56) Documents cités:
- EP-A- 0 370 443
- EP-A- 0 651 477
- US-A- 4 400 813
- IEEE JOURNAL OF QUANTUM ELECTRONICS, vol. 30, no. 11, 1 Novembre 1994, pages 2458-2466, XP000478000 DAVIS M G ET AL: "A TRANSFER MATRIX METHOD BASED LARGE-SIGNAL DYNAMIC MODEL FOR MULTIELECTRODE DFB LASERS"

## Description

La présente invention concerne la conception et la réalisation des dispositifs d'émission et/ou réception de faisceaux de lumière laser intervenant dans la transmission d'informations à distance par voie optique. Elle porte plus particulièrement sur les dispositifs qui utilisent la modulation d'un faisceau laser pour traduire des informations numériques sous forme de signaux électriques.

Dans ce cadre, et d'une manière générale, le faisceau porteur des informations est monochromatique à une fréquence accordée à l'identique au niveau du laser émetteur et au niveau du laser récepteur. Il est véhiculé de l'un à l'autre par une fibre optique.

On connaît ainsi différentes sortes de lasers à semi-conducteurs, qui se présentent sous de très faibles dimensions et qui servent notamment à l'émission ou la réception d'informations véhiculées de l'émetteur au récepteur par l'intermédiaire de fibres optiques. On peut y distinguer les lasers dits verticaux et les lasers dits horizontaux. Dans un cas comme dans l'autre, si l'on considère par exemple le laser émetteur, les solutions modernes consistent à assurer l'émission stimulée de lumière dans un guide d'ondes en matériau actif semi-conducteur et à provoquer la modulation en appliquant à ce guide d'ondes un courant électrique placé sous la commande d'une tension d'excitation traduisant des informations binaires à transmettre pour faire varier en conséquence l'émissivité du matériau actif ou son indice de réfraction.

A titre de référence concernant l'art antérieur à la présente invention, on peut citer en particulier le document de brevet FR 2 639 773, qui rappelle le principe des lasers à semi-conducteur à rétro-alimentation (ou contre-réaction) distribuée, dits de type DFB, incorporant un réflecteur de Bragg (DBR). Une diode laser émettrice de ce type, réalisée en structure monolithique, comprend des couches superposées définissant un guide de lumière limité par des couches de confinement, qui est lui-même constitué par un ruban de matériau actif électro-optique doublé d'une couche passive. Suivant la direction supposée horizontale de propagation de la lumière, on distingue principalement une section d'amplification d'une émission photonique stimulée à une longueur d'onde dépendant du matériau utilisé, une section d'accord de phase, et une section à stratification périodique de Bragg, dont la périodicité est liée à un réseau de diffraction gravé dans la couche passive adjacente de sorte à induire une variation d'épaisseur du guide d'ondes.

Le faisceau lumineux est émis suite à la libération de photons sous l'effet d'un courant d'excitation injecté au niveau de la première section du laser et à l'amplification sélective de la longueur d'onde dite de Bragg provoquée par résonance entre le réseau de Bragg et un miroir réflecteur opposé. Une modulation de cette longueur d'onde dans la lumière quittant le laser est obtenue en commandant une variation de l'indice de réfraction effectif du matériau actif par un courant électrique appliqué à travers la section formant réseau.

Le document EP 0395 315 décrit un laser de type différent, appartenant à la classe des lasers dits verticaux. Dans ce cas, la stratification de Bragg du matériau semi-conducteur se répartit non plus dans le sens longitudinal du laser, mais en couches superposées parallèles au substrat supportant l'ensemble, de sorte que l'émission de lumière se produit en surface du laser perpendiculairement à la direction longitudinale, alors que dans les lasers horizontaux, le faisceau sort par la tranche du laser. Le même document décrit aussi avec amples détails la manière dont sont obtenues les propriétés utiles localement dans chaque zone fonctionnelle à partir d'un même cristal semi-conducteur, grâce à la création de propriétés différentes en signe des porteurs libres et en dopage.

Dans la pratique, s'agissant du domaine de la communication par transmission de données via des fibres optiques, les recherches se sont surtout attachées ces dernières années à réduire les dimensions des dispositifs à lasers émetteurs et récepteurs et à améliorer la qualité par la précision de la fréquence porteuse et le gain en amplitude apportés par les réseaux de diffraction de Bragg limitant la cavité résonante dans des structures monolithiques en matériau transparent. Les perspectives de développement des applications de telles structures sont largement liées à la capacité que l'on a su acquérir de constituer les couches successives nécessaires par des techniques telles que la croissance épitaxique moléculaire et le dépôt chimique en phase vapeur.

Mais l'industrie reste toujours dans l'expectative de voir s'accroître la quantité d'informations transmissibles par unité de temps.

Pour y parvenir, la présente invention propose essentiellement de combiner les principes connus des dispositifs actuels à laser, avec un mode d'excitation nouveau du matériau actif qui provoque sa stratification en structure de Lippmann ayant un profil ajustable à chaque instant.

Le phénomène qui a été constaté par Lippmann il y a un siècle réside dans le fait que moyennant réflexion sur un miroir, les différentes fréquences lumineuses d'une image en couleurs se traduisent par la formation d'ondes stationnaires qui impriment de fines stratifications dans l'épaisseur d'une couche photosensible.

L'holographie traditionnelle n'exploite pas le même phénomène, car il n'y a pas formation de fines stratifications comme dans une structure de Lippmann. Les franges d'interférences qui produisent l'image tridimensionnelle y sont larges, en surface d'une couche mince. Elles résultent en un réseau de diffraction qui procède non par réflexion, mais en dispersant angulairement la lumière comme un prisme. Rappelons toutefois qu'il a été proposé d'exploiter l'effet Lippmann dans une technique d'holographie dite de volume, ou de Lippmann, qui permet d'obtenir des hologrammes monochromes ou en couleurs, qui sont observables en lumière blanche.

De fines stratifications à l'intérieur des figures d'interférences réfléchissent alors sélectivement les longueurs d'ondes lumineuses utilisées lors de l'enregistrement.

D'autre part, une demande de brevet déposée le même jour par le même demandeur sous priorité du brevet France n° 95 06554, décrit l'utilisation de l'effet Lippmann au sein de fibres optiques pour enregistrer dans celles-ci de l'information sous une forme particulièrement dense.

Les phénomènes d'interférence sont aussi utilisés dans les lasers semi-conducteurs actuels, quand ils comportent un réflecteur de Bragg pour accorder le faisceau véhiculé dans le guide d'ondes sur une fréquence lumineuse bien déterminée. Mais dans ce cas, on vise exclusivement à faire entrer le guide d'ondes en résonance sur la fréquence désirée, de manière à obtenir un faisceau véritablement monochromatique. L'effet Bragg représente un cas particulier de l'effet Lippmann et il conduit à une structure stratifiée qui comporte une seule périodicité.

Dans le cadre de la communication d'informations par voie optique, la présente invention a pour objet un procédé ainsi que des dispositifs pour sa mise en oeuvre, présentant les caractéristiques qui seront revendiquées ci-après, considérées séparément ou dans toute combinaison techniquement opérante.

Suivant un mode de réalisation préféré de l'invention, on injecte dans le guide d'ondes (ou guide de lumière) en matériau électro-optique actif d'un laser émetteur de type par ailleurs en soi connu, notamment au niveau d'un réseau de Bragg dont l'indice de réfraction varie en fonction d'un courant électrique qui le traverse, une série de courants de modulation différents, respectivement appliqués par des électrodes distinctes en des segments de matériau actif régulièrement espacés le long de la direction de propagation de la lumière formant une structure à stratification de Lippmann .

On réalise ainsi la transmission de données par faisceau laser en véhiculant ce faisceau par réflexions successives en guidage monomode le long d'une fibre optique en couplage optique avec le laser émetteur, sous forme d'une multitude de longueurs d'ondes lumineuses qui se cumulent, emportant avec le spectre résultant, l'ensemble des informations amenées par les différents courants d'excitation injectés au niveau de la modulation, chacun de ces courants étant modulable indépendamment des autres.

A l'autre extrémité d'une telle fibre de transmission par voie optique, on dispose un laser récepteur faisant application de la présente invention de manière symétrique au laser émetteur, mais cette fois en absorption plutôt qu'en émission de lumière.

La différence essentielle réside dans le fait que le matériau actif émissif de photons est remplacé par un matériau photosensible, de telle sorte que les variations de longueur d'onde cumulatives qui parviennent au laser récepteur induisent par effet Lippmann des modulations correspondantes dans des signaux électriques reçus par une série d'électrodes régulièrement espacées comme dans le laser émetteur. Il s'agit d'une version photo-électrique du procédé Lippmann de photographie en couleurs ; les microcristaux de bromure d'argent utilisés dans ce dernier sont ici remplacés par une série d'éléments photosensibles individuellement reliés à une série d'électrodes.

En termes scientifiques, on peut s'exprimer plus simplement en indiquant que le laser émetteur à électrodes multiples réalise une transformation de Fourier de la distribution représentant à un instant donné l'ensemble des signaux porteurs d'informations électriques lors de leur passage en forme de spectre optique, et qu'à la réception on récupère ces signaux en opérant une transformation de Fourier inverse de la forme optique à la forme électrique.

Les différentes électrodes d'excitation agissant sur l'indice de réfraction et le gain émissif du guide d'ondes photo-émissif fournissent en quelque sorte une série de canaux de communication utilisés en multiplexage dans l'émission d'informations à l'entrée d'une fibre optique. A l'autre extrémité de celle-ci, les opérations de démultiplexage procèdent de la même manière pour récupérer les signaux reçus vers des liaisons électriques appropriées respectivement connectées aux différentes électrodes de la diode laser de réception.

On notera ici qu'il est parfois question de multiplexage dans l'art antérieur, mais il s'agit alors uniquement, contrairement à l'invention, de combiner à l'entrée d'une même fibre optique des faisceaux laser provenant de diodes émettrices différentes, et à la réception, il doit être procédé à une analyse du spectre lumineux par d'autres moyens.

Suivant l'invention, grâce à une démultiplication des électrodes de modulation, c'est par émission d'un faisceau laser unique qu'on assure le multiplexage. Et si à la réception, il est possible d'utiliser tous moyens pour analyser le spectre transmis par voie optique, il est préférable, tant pour la commodité et l'efficacité que pour la sécurité dans la fiabilité des informations, d'opérer également au moyen d'un laser détecteur unique.

Suivant un mode de mise en oeuvre particulièrement avantageux de l'invention, dans son application à la communication par fibres optiques, on agit sur la structure de résonance à réflecteur de Bragg d'un laser, point par point localement, et de la sorte, par une commande admettant une tension électrique séparément à chacune des électrodes, on assure la modulation individuelle de chacune des différentes longueurs d'ondes qu'elle est capable de générer simultanément dans une structure de Lippmann. La commande de tension peut être au plus simple en tout ou rien, mais elle peut aussi être proportionnelle en forme analogique.

On décrira maintenant plus en détail des formes de réalisation particulières de l'invention qui en feront mieux comprendre l'objet avec ses caractéristiques essentielles et ses avantages, étant entendu toutefois que dans leurs détails, ces formes de réalisation sont choisies à titre d'exemples non limitatifs

Cette description est illustrée par les dessins annexés, dans lesquels :
- La figure 1 montre une coupe schématique d'un laser émetteur de type vertical suivant l'invention ;
- La vue en perspective de la figure 2 représente de la même manière un laser vertical produisant plusieurs faisceaux de lumière laser, chacun conformément à l'invention ;
- La figure 3 illustre un détail des couches d'un tel laser ;
- La figure 4 illustre l'invention dans le principe de son application au cas d'un laser horizontal vu en coupe ;
- La figure 5 montre le même laser horizontal en vue de dessus, avec un schéma de distribution des tensions de modulation à un instant déterminé ;
- La figure 6 schématise une partie agrandie du dispositif émetteur laser des figures 4 et 5 en fonctionnement, et illustre un spectre lumineux instantané ;
- La figure 7 montre une série de tels spectres en relation avec des profils d'excitation différents.

Que la diode laser soit de type horizontal (faisceau émis par la tranche d'un laser à semi-conducteur) ou de type vertical (émission perpendiculairement à la surface), il reste que suivant l'invention, on respecte le principe des diodes laser classiques de type monolithique qui consiste à émettre ou détecter des informations véhiculées par un faisceau laser (généralement transmis par fibre optique, entre émetteur et détecteur récepteur) dont l'amplitude ou la fréquence de base est modulée en fonction desdites informations. Ces dernières peuvent être plus ou moins sous forme de trains d'impulsions calibrées.

Dans le cas de lasers horizontaux, il est formé une cavité de résonance entre deux réflecteurs, dont dans l'exemple décrit plus particulièrement ici, l'un au moins implique un réseau de Bragg obtenu grâce à des ondulations physiques à périodicité déterminée constante, faisant varier l'épaisseur de la couche active de semi-conducteur vue dans le sens longitudinal du guide de lumière incorporé dans la structure monolithique du laser.

Dans le cas des lasers verticaux, on retrouve une structure de réseau réflecteur jouant le même rôle de résonance pour une fréquence prédéterminée, mais cette fois il s'agit d'une pluralité de couches superposées formées parallèlement à la surface du guide de lumière émetteur (ou récepteur) propre du laser, si bien que le faisceau porteur d'informations est perpendiculaire à cette surface.

Dans un cas comme dans l'autre, l'excitation d'un laser émetteur s'effectue par application d'une tension électrique modulatrice du signal optique entre deux électrodes placées de sorte à faire varier l'indice de réfraction et/ou le gain émissif au sein des couches ou tranches successives de la structure formant le réseau de Bragg. Et de manière symétrique, la détection s'effectue, au sein de la structure à matériau photosensible, par action sur un courant électrique récepteur en fonction du faisceau incident porteur d'informations.

Par rapport à cet état de la technique, l'invention consiste essentiellement à segmenter ou démultiplier les électrodes qui font passer les informations de leur forme électrique à leur forme codée optique et vice-versa.

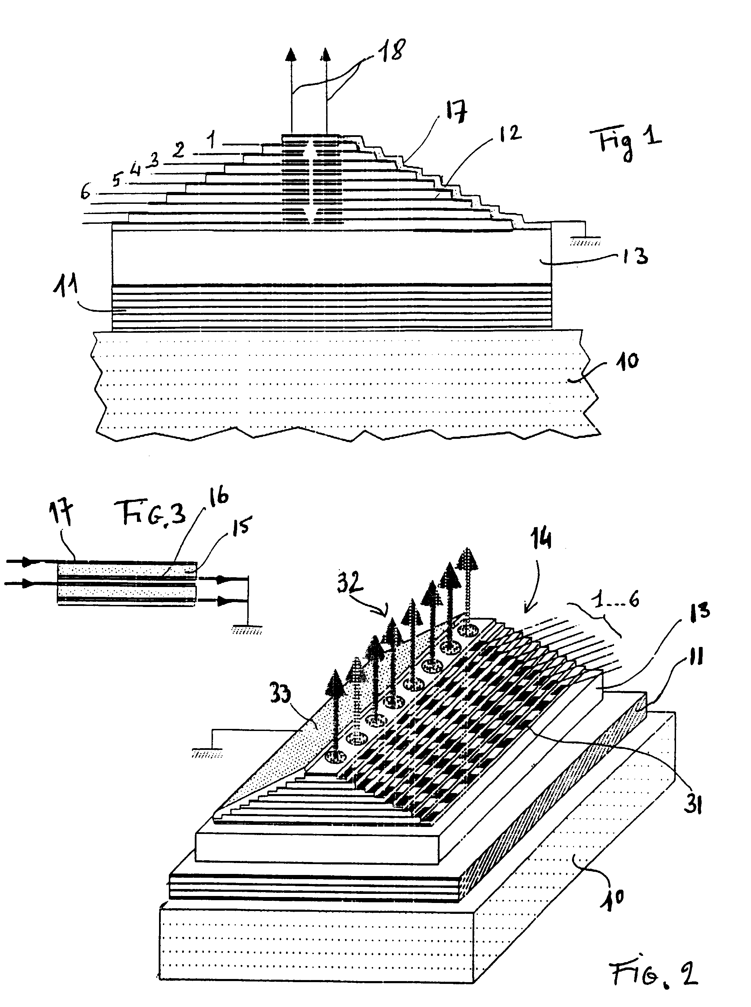

Dans une forme de réalisation suivant l'invention particulièrement élaborée, les figures 1 et 2 illustrent schématiquement une diode laser utilisée en émetteur. La démultiplication des électrodes y est concrétisée de sorte à transmettre, dans chacun des faisceaux laser émis, les informations multiplexées d'une série de signaux électriques.

La figure 1 montre un faisceau unique de sortie, alors que la vue en perspective de la figure 2 montre une série de faisceaux adjacents, parallèles les uns aux autres, émis simultanément. Chaque faisceau porteur d'informations est alors transmis à distance par une simple fibre optique, connectée en couplage optique avec le point d'émission correspondant en sortie du laser, d'une manière qui est en elle-même classique.

On voit sur ces figures que la structure laser monolithique à semi-conducteur, de type vertical, comporte, en couches superposées sur un substrat 10, d'abord un réflecteur optique 11, constitué en fait d'une série de couches identiques alternativement de deux indices de réfraction différents, puis une couche de transmission inactive 13, jouant un rôle d'espaceur intermédiaire avant un empilement actif 12, également constitué de couches superposées.

C'est au niveau de cet empilement de couches 12 que s'effectue la commande de modulation, par excitation par un courant électrique porté à un potentiel variable par rapport à une électrode à la masse.

Pour un fonctionnement optimal, il est prévu que chaque couche active présente, le long de l'axe, une épaisseur correspondant au maximum au quart de la longueur d'onde de base du faisceau lumineux 18 émis perpendiculairement aux couches.

Conformément à l'invention, et comme le montre mieux le détail de la figure 3, chacune des couches, ici numérotées de 1 à 6 dans l'empilement (qui peut en comporter plusieurs dizaines ou centaines), est encadrée de ses propres électrodes. Ainsi, la couche 15 (figure 3), en matériau semi-conducteur à base d'arséniure de gallium par exemple, est intercalée entre une couche transparente électriquement conductrice 16, qui est reliée à la masse, et une couche électriquement conductrice 17, à laquelle est appliqué un courant d'excitation modulé, de manière spécifique à la couche 15. La modulation a pour effet de faire varier plus ou moins les paramètres électro-optiques fonctionnels de la couche active que sont le gain émissif et l'indice de réfraction effectif, par rapport aux valeurs nominales de ces paramètres à courant constant.

Une couche isolante du point de vue électrique sépare deux électrodes juxtaposées intervenant respectivement à l'entrée et à la sortie d'un courant d'excitation pour deux couches successives.

On a cherché à faire ressortir schématiquement sur la figure 1 que la partie de chaque couche 15 qui est active en émission photonique, et participe de ce fait au réseau stratifié de Lippmann, est en pratique réduite à une bande centrale sur une zone de même largeur d'une couche à l'autre.

Cette particularité a spécialement sa raison d'être, quand, comme illustré, les couches superposées sont formées dans une structure semi-conductrice à gradins, avec une largeur allant en décroissant du substrat (plus exactement de la couche inactive 13) à la sortie du faisceau laser 18 produit. Une telle disposition en escalier facilite considérablement la réalisation des connexions électriques nécessaires de chaque côté.

Du côté des électrodes d'entrée 1...6 amenant les courants d'excitation, chaque couche électriquement conductrice est accessible en surface de la couche active 15 correspondante. Du côté opposé, la couche électrode de sortie est accessible en surface de la couche active immédiatement sous-jacente dans l'empilement. Le courant est la repris vers la masse par une couche de revêtement électriquement conductrice qui recouvre l'ensemble de la surface des gradins, par exemple une couche de métallisation continue 17.

Qu'elles soient à fonction essentiellement optique ou à fonction essentiellement électrique, les différentes couches de l'empilement, qui se succèdent de manière répétitive et qui sont toutes transparentes à la lumière aux longueurs d'onde laser, peuvent être constituées, suivant des méthodes en soi classiques, en partant d'un substrat monolithique.

De ce point de vue, de nombreux documents accessibles à l'homme de l'art ont largement publié la manière dont peuvent être appliquées, notamment, les techniques de croissance épitaxique moléculaire ou de dépôt chimique en phase vapeur, pour créer des couches différenciées en signe et/ou en densité des porteurs libres, ainsi que des couches formant électrodes surfaciques transparentes.

Le fonctionnement du laser émetteur qui vient d'être décrit est en soi classique pour ce qui concerne la formation d'une cavité de résonance (ici verticale) entraînant l'émission d'un faisceau lumineux cohérent monochromatique, à une longueur d'onde de base qui dépend de l'indice des couches optiquement actives et du pas de leur répétition spatiale apportant l'effet de réseau stratifié.

Plus précisément, une longueur d'onde λ est sélectivement amplifiée par l'apparition d'ondes stationnaires dans l'empilement quand le pas d'espacement entre couches est égal à λ/2 pour l'indice de réfraction effectif créé sous l'influence du courant d'excitation nominal.

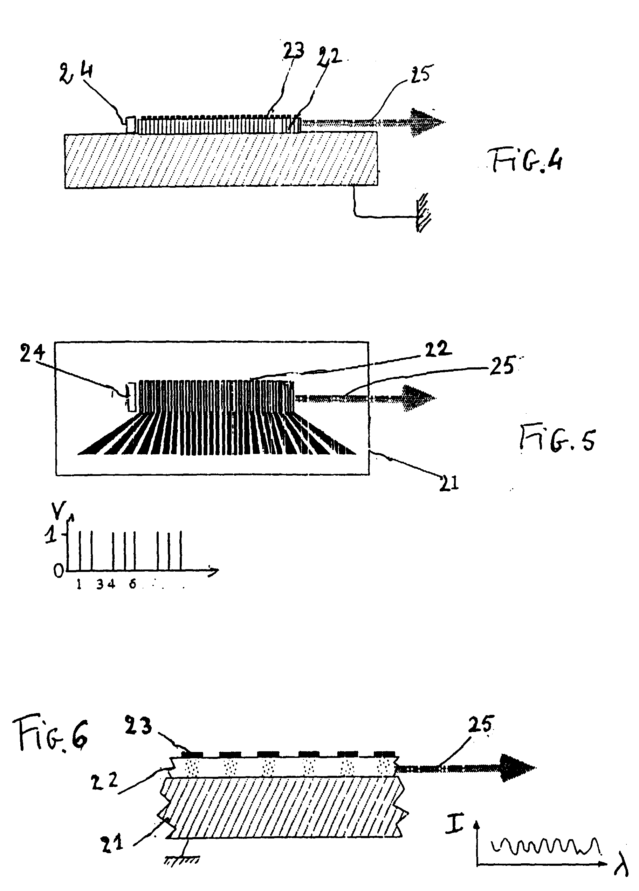

L'invention combine à la solution usuelle une modulation du courant électrique faisant varier les paramètres de gain émissif et/ou indice effectif du matériau actif qui est appliqué individuellement à chacune des couches. Chaque modulation traduit des informations, en général binaires, véhiculée par le courant injecté à l'électrode d'entrée d'une couche. Elle s'exerce de manière temporelle, en variations de tension entre des impulsions à front abrupt dans l'exemple considéré ici. L'ensemble intégrant les différents courants présente une distribution spatiale propre à chaque instant du genre de celle qui est illustrée sur la figure 5.

Dès lors, le spectre instantané du rayon lumineux émis est la transformée de Fourier de la distribution des tensions d'excitation modulées, cumulant à chaque instant l'ensemble des impulsions appliquées aux différentes couches actives par leurs électrodes d'entrée respectives, avec pour chacune un poids identique dans la mesure où l'interaction des électrodes est linéaire.

En pratique, le comportement des électrodes est effectivement de type linéaire quand les tensions d'excitation restent relativement faibles. Pour de fortes émissions, des comportements non linéaires ont tendance à apparaître, et le spectre émis à un instant n'est plus exactement une simple transformation de Fourier des signaux d'excitation.

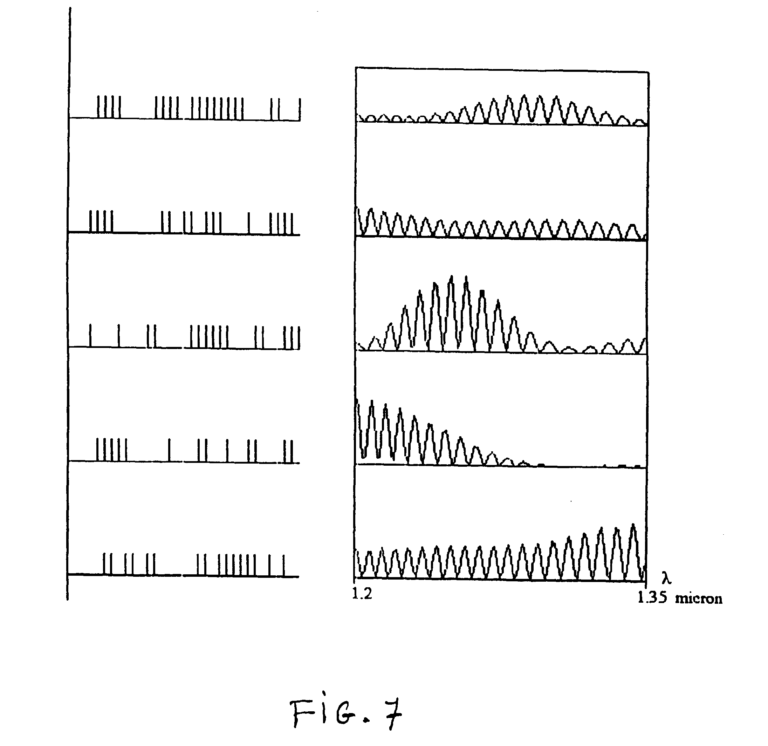

En d'autres termes, alors que les longueurs d'ondes émises correspondent à des ondes stationnaires ayant leur maxima au sein des couches actives émissives, une combinaison linéaire de l'effet des différentes excitations, commandées indépendamment l'une de l'autre via les électrodes, conduit à un spectre instantané d'intensité en lumière laser schématiquement illustré sur la figure 6, qui représente l'équivalent codé par transformation de Fourier de la répartition des modulations reçues simultanément par les différentes électrodes équidistantes dans l'espace. On a ainsi réalisé le multiplexage des informations d'entrée.

La figure 7 représente mieux une série de spectres différents, obtenus (à droite) sur des longueurs d'ondes de 1,2 à 1,35 microns, en correspondance avec la composition (à gauche) des signaux d'excitation. Il s'agit de résultats de calcul par transformation de Fourier, pour lesquels on a supposé que les signaux d'excitation sont de type tout-ou¶ rien. La géométrie du laser dans ce cas comporte un miroir d'extrémité espacé à 30 microns de la zone segmentée active, laquelle contient 30 électrodes espacées de 200 nanomètres. L'indice de réfraction moyen du matériau est 1,5.

A titre d'exemple, si à un instant déterminé, le laser émetteur décrit se voit appliquer la même modulation dans le courant d'excitation une électrode sur deux, le faisceau laser émis présente une configuration équivalente à celle d'un laser à contre-réaction distribuée par un réseau de Bragg, véhiculant une longueur d'onde unique prédéterminée pour un écartement approprié entre les couches soumises au courant d'excitation et le miroir réflecteur opposé.

Une simulation sur ordinateur passant par la cumulation linéaire des différents spectres correspondant à des stimulations étagées différemment, démontre qu'il est souhaitable de fixer l'épaisseur de la couche intermédiaire d'espacement 13 de la cavité de résonance de sorte que le spectre optique résultant ne s'étende pas sur une bande trop large, en vue d'une analyse de ce spectre qu'il est utile de pouvoir effectuer dans des conditions optimales de fidélité.

De telles exigences sont satisfaites si, par exemple, la couche 13 présente une épaisseur de 30 000 nanomètres, et si le pas d'échantillonnage entre électrodes de même polarité est de 200 nanomètres, pour un rayonnement laser dont la longueur d'onde varie de pas plus de 1 % par rapport à une émission monochromatique de base de l'ordre de 0,4 à 1 micron en fonction des courants individuels d'excitation modulée.

La transmission de l'information à véhiculer par fibre optique ne pose pas de problème particulier. A titre comparatif, on sait véhiculer ainsi des signaux optiques multiplexés, en un très grand nombre de canaux de transmission portés sur une même fibre optique. Tel est le cas de situations connues dans le domaine de la télévision, pour un multiplexage de 100 à 1 000 canaux de communication, étant entendu que contrairement à la présente invention, les multiplexages connus s'effectueraient à partir d'autant de lasers émetteurs qu'il y a de canaux, et non pas à partir d'une structure de diode laser unique comme il est décrit ici.

Dans un exemple conforme à l'invention, pour une émission se situant à l'intérieur d'une bande spectrale de 1 à 1,01 micron, l'empilement 14 comprend 100 ensembles répétitifs de couches, avec un pas d'espacement entre couches identiques égal à 0,2 micron, et la bande de zone active de chaque couche modulable en ses propriétés électro-optiques présente une largeur de 20 microns. D'une manière générale, on peut observer que pour une même longueur d'onde du faisceau émis, on prévoit ici des couches deux fois plus serrées que dans les empilements des lasers connus, une électrode sur deux étant excitée par le courant à la tension de modulation et l'autre étant à la masse. Les impulsions peuvent par exemple se succéder à une fréquence de 5 à 10 MHz, qui peut même égaler une valeur de l'ordre d'au moins 1 gigaherz.

Si l'on se réfère maintenant spécialement à la figure 2, on peut y constater que sur la longueur du même empilement, les différentes couches conductrices d'injection de courant sont divisées en bandes parallèles 31, toutes à la verticale les unes des autres d'une couche à l'autre. Par le même dispositif émetteur laser monolithique, on peut ainsi produire une pluralité de faisceaux verticaux 32, qui présentent chacun un spectre dérivant d'une structure à stratifications de Lippmann réalisée suivant l'invention et emportant avec lui les informations amenées aux bandes d'électrode correspondantes. Dans ce cas également, l'électrode à la masse 33 est commune à toutes les bandes d'électrode associées à tous les faisceaux.

A propos de la conception de lasers horizontaux suivant l'invention, on pourra se reporter, pour ce qui concerne leur particularités équivalentes à la conception classique des lasers verticaux, aux documents de brevets accessibles à l'homme de l'art, lesquels ne manquent pas d'exemples, souvent moins récents que les lasers verticaux.

Cependant, les figures 4 à 6 illustrent très schématiquement une forme de réalisation de l'invention appliquée à ce cas.

On voit ainsi sur la figure 4 le substrat 21, relié électriquement à la masse, de sorte à constituer l'une des électrodes, celle qui est unique dans le dispositif laser émetteur considéré. La face supérieure de ce substrat supporte une couche de semi-conducteur en forme de ruban 22, où s'effectue l'émission de lumière laser, pour produire un faisceau longitudinal 25 qui sort par la tranche du laser. A l'autre extrémité, le laser est fermé par un miroir 24. Le ruban 22 sera souvent incrusté dans un sillon du substrat. Il peut être doublé d'une ou plusieurs couches complémentaires, sur l'une et l'autre de ses faces, par exemple pour créer par la une structure de puits quantiques.

Une seconde couche électriquement conductrice 23 recouvre le ruban 22, mais elle est elle segmentée en bandes transversales au ruban. Tous les segments d'électrode forment ainsi des électrodes individuelles pour injecter au laser des courants de modulation distincts, chacun à tension variable commandée par les signaux électriques dont il est porteur. Une couche isolante non représentée sépare le substrat 21 des bandes de couche conductrice sur les bords du ruban émetteur 22. Le ruban 22 est également segmenté parallèlement aux bandes de la couche conductrice 23, en regard de celles-ci.

Pour la couche 23 comme pour le ruban 22, le pas de segmentation est choisi inférieur au quart de la longueur d'onde (mesurée dans le milieu optique) la plus courte qu'il est prévu d'émettre en sortie du laser dans le faisceau 25. En fonction du signal électrique qui lui est appliqué, chaque segment d'électrode modifie les paramètres électro-optiques du segment de ruban émetteur situé en regard, influençant ainsi les modes de résonance du laser dans son ensemble, et donc le spectre du faisceau de lumière 25 qu'il émet.

De préférence, le ruban guide d'ondes 22 présente une épaisseur inférieure au pas de la segmentation ci-dessus. Sous une telle condition, on peut se dispenser d'une stratification physique du guide de lumière en ses propriétés intrinsèques, car on ne court plus le risque que les actions de modulation affectent le guide de lumière de part et d'autre de la strate en regard du segment d'électrode apportant le signal électrique de modulation.

Comme le montre la figure 5, les différentes bandes d'électrode segmentée se prolongent sur le substrat, d'un côté du laser proprement dit, par des conducteurs qui s'élargissent en éventail. Cette disposition est destinée à faciliter les connexions électriques avec des conducteurs extérieurs au laser, propres à assurer l'alimentation en courants de modulation.

On comprend de ce qui précède que par rapport à l'art antérieur, suivant lequel la structure de Bragg classique est monochromatique, à période constante fixe et réflexion d'une seule longueur d'onde, ajustée et soumise à modulation en fonction d'un indice de réfraction effectif moyen de la structure, l'invention conduit à combiner avec des structures Lippmann qui se trouvent créées par la fragmentation en une série périodique de segments actifs, de l'électrode de modulation et/ou du guide de lumière, au niveau du réseau de Bragg. On assure alors, vers une même fibre à partir d'un laser unique, l'émission simultanée d'une multitude de longueurs d'ondes, séparément modulables dans leur action sur les modes axiaux du laser, c'est-à-dire sur le spectre optique instantané du faisceau lumineux émis.

De ce fait, les informations d'entrée se trouvent multiplexées dans le spectre des longueurs d'ondes véhiculées par une fibre guide d'ondes en couplage optique avec le laser. En cela, l'invention se démarque radicalement des solutions de multiplexage qui ont déjà été parfois proposées, dans la mesure où ces dernières demandent de coupler à une même fibre plusieurs lasers distincts, avec chacun une seule entrée pour un signal électrique de modulation, et où elles entraînent alors de nombreux inconvénients, notamment en complexité, coût et insécurité de mise en oeuvre.

## Revendications

1. Procédé de communication par transmission d'informations par voie optique, caractérisé en ce que ladite transmission s'effectue dans une fibre optique en forme codée transportée par un spectre correspondant sensiblement à la transformée de Fourier d'un ensemble d'informations, alimentant sous forme de signaux électriques un dispositif d'émission laser, par injection dans le guide de lumière en matériau photo-émissif actif de ce laser d'une série de courants électriques de modulation individualisés, appliqués à travers le milieu photo-émissif (12;14) à une multitude d'électrodes distinctes (1-6), régulièrement espacées le long du trajet du faisceau laser émis (18), de sorte à réaliser une structure électro-optique à stratifications de Lippmann.

2. Procédé suivant la revendication 1, caractérisé en ce que lesdits courants sont injectés au niveau d'un réseau de Bragg dans un laser à contre-réaction distribuée.

3. Dispositif de communication par transmission d'informations par voie optique faisant application du procédé selon la revendication 1 ou 2, caractérisé en ce qu'il comporte au moins un dispositif d'émission laser dans le guide de lumière photo-émissif actif (12;14) duquel il est créé une structure à stratification de Lippmann comportant une série de segments (15) régulièrement espacés le long du trajet d'un faisceau de lumière émis, et en ce qu'il est associé à chacun desdits segments des moyens de modulation pour injecter individuellement dans chacun desdits segments un courant d'excitation porteur d'informations en signaux électriques.

4. Dispositif d'émission laser pour la mise en oeuvre du procédé suivant la revendication 1 ou 2, comportant des moyens de modulation d'un faisceau laser (18) émis dans un guide de lumière en matériau photo-émissif actif (12;14), caractérisé en ce que lesdits moyens comportent une série d'électrodes distinctes (1-6) régulièrement espacées le long du trajet dudit faisceau, chacune en connexion électrique pour recevoir un courant de modulation individualisé, de sorte à créer dans ledit guide de lumière une structure à stratification de Lippmann

5. Dispositif selon la revendication 4 à laser de type horizontal, dans lequel ledit guide de lumière en matériau photo-émissif est sous forme d'un ruban (22) et en ce que le pas desdites électrodes est inférieur au quart de la longueur d'onde la plus courte à émettre par le laser.

6. Dispositif selon la revendication 5, caractérisé en ce que ledit ruban (22) présente une stratification en gain émissif et/ou indice de réfraction au même pas de segmentation en regard desdites électrodes (23).

7. Dispositif selon la revendication 5 ou 6, caractérisé en ce que l'épaisseur dudit ruban (22) est inférieure audit pas des électrodes (23).

8. Dispositif selon la revendication 5 à laser du type vertical comportant un réseau de Bragg formé par un empilement (12) de couches (15) de matériau photo-émissif, caractérisé en ce que lesdits courants de modulation sont appliqués séparément à des électrodes (17) formées sur chacune desdites couches.

9. Dispositif selon la revendication 7, caractérisé en ce que chaque couche de l'empilement (12) présente une épaisseur correspondant au maximum au quart de la longueur d'onde du faisceau (18) émis à travers l'empilement.

10. Dispositif de réception laser pour la mise en oeuvre du procédé suivant la revendication 1 ou 2, caractérisé en ce qu'il présente une structure analogue à celle d'un dispositif d'émission laser suivant l'une quelconque des revendications 4 à 9 dans laquelle le matériau photo-émissif est remplacé par un matériau photo-sensible , de telle sorte que les variations de longueur d'onde cumulatives qui parviennent au dit dispositif de réception laser induisent par effet Lippmann des modulations correspondantes dans des signaux électriques reçus par une série d'électrodes régulièrement espacées comme dans le dit dispositif d'émission laser.

## Patentansprüche

1. Verfahren zur optischen Nachrichtenübertragung, dadurch gekennzeichnet, dass die Übertragung in einer codierten Form in einer Lichtleitfaser, die von einem Spektrum getragen wird, vonstatten geht, das merklich der Fourier-Transformation einer Informationseinheit entspricht, um in der Form von elektrischen Signalen eine Vorrichtung für Laserübertragungen zu speisen, dadurch, dass in dem aus aktivem Photoemissionsmaterial bestehenden Lichtleiter dieses Laserstrahls eine Reihe von unabhängigen, elektrischen Modulationsströmen eingespeist wird, welche durch ein Photoemissionsmittel (12, 14) hindurch an eine grosse Anzahl unterschiedlicher Elektroden (1-6) angesetzt werden, die in gleichmässigen Abständen auf dem ausgestrahlten Laserstrahlverlauf (18) liegen, so dass eine elektro-optische Struktur von Lippmann-Schichtungen entsteht.

2. Verfahren nach Anspruch 1, dadurch gekennzeichnet, dass der Strom in ein Bragg-Netz in einen Laser mit verteilter Gegenkopplung eingespeist wird.

3. Vorrichtung zur optischen Nachrichtenübertragung unter Anwendung des Verfahrens nach Anspruch 1 oder 2, dadurch gekennzeichnet, dass sie mindestens eine Vorrichtung für Laseremission in dem aktiven Photoemissionslichtleiter (12;14) beinhaltet, wobei in letzterem eine elektro-optische Struktur von Lippmann-Schichtungen aus einer Reihe von in gleichmässigen Abständen auf dem ausgestrahlten Lichtstrahl liegenden Segmenten (15) entsteht und dadurch gekennzeichnet, dass jedem dieser Segmente Modulationsmittel zugeordnet sind, um ihnen individuell einen Erregerstrom einzuspeisen als Informationsträger für elektrische Signale.

4. Vorrichtung für Laseremission zur Durchführung des Verfahrens nach Anspruch 1 oder 2, das in einem Lichtleiter aus aktivem Photoemissionsmaterial (12;14) Modulationsmittel eines ausgestrahlten Laserstrahlverlaufs (18) enthält, dadurch gekennzeichnet, dass diese Modulationsmittel eine Reihe unterschiedlicher Elektroden (1-6) beinhalten, die in gleichmässigen Abständen auf dem Laserstrahlverlauf liegen, alle untereinander elektrisch verbunden, um einen unabhängigen Modulationsstrom zu empfangen, so dass auf dem Lichtleiter eine Struktur von Lippmann-Schichtungen entsteht.

5. Vorrichtung nach Anspruch 4 mit waagerechtem Laser, in dem der Lichtleiter aus aktivem Photoemissionsmaterial die Form eines Bandes (22) hat, dadurch gekennzeichnet, dass der Abstand der Elektroden unterhalb eines Viertels der kürzesten vom Laser auszustrahlenden Wellenlänge liegt.

6. Vorrichtung nach Anspruch 5, dadurch gekennzeichnet, dass das Band (22) eine Schichtung von emittierendem Übertragungsverstärker aufweist und/oder ein Refraktionsindiz in demselben Segmentabstand wie bei den Elektroden (23).

7. Vorrichtung nach Anspruch 5 oder 6, dadurch gekennzeichnet, dass die Dicke des Bandes (22) geringer ist als der Abstand der Elektroden (23).

8. Vorrichtung nach Anspruch 5 mit senkrechtem Laser mit einem Bragg-Netz, das aus einer Aufschichtung (12) von Lagen (15) aus Photoemissionsmaterial besteht, dadurch gekennzeichnet, dass der Modulationsstrom getrennt an die Elektroden (17) auf jeder der Schichten angesetzt wird.

9. Vorrichtung nach Anspruch 7, dadurch gekennzeichnet, dass jede Lage der Aufschichtung (12) eine Dicke aufweist, die höchstens ein Viertel der Wellenlänge des Laserstrahls (18), der durch die Aufschichtung hindurchdringt, beträgt.

10. Laserempfangsvorrichtung für die Durchführung des Verfahrens nach Anspruch 1 oder 2, dadurch gekennzeichnet, dass sie eine fast gleiche Struktur aufweist wie die einer Laserausstrahlvorrichtung nach einem der Ansprüche 4 bis 9, bei dem das Photoemissionsmaterial durch photosensibles Material ersetzt wird, so dass die summierten Variationen der Wellenlängen, die bis zur Vorrichtung für den Laserempfang gelangen, durch einen Lippmann-Effekt entsprechende Modulationen hervorrufen in elektrischen Signalen, die, wie in der Laserausstrahlvorrichtung, von einer Reihe von gleichmässig entfernten Elektroden empfangen wird.

## Claims

1. A process for communication involving information data transmission by optical means, characterized in that said transmission occurs in an optical fiber in coded form carried by a spectrum corresponding to the Fourier transform of a data set, fed in the form of electrical signals into a laser emission device, through injecting in the active photo-emissive material of said laser's light guide a series of individualized modulating electrical currents, applied across said photo-emissive medium (12, 14) to distinct electrodes (1-6) evenly spaced along the path of the emitted laser beam (18), to produce thereby an electro-optical structure with Lippmann stratifications.

2. A process according to claim 1, characterized in that said currents are injected into a Bragg array in a laser with distributed feedback.

3. A device for communication by transmission of information data by optical means along with the process according to claim 1 or 2, characterized in that it comprises at least one laser emission device in the active photo-emissive light guide (12, 14), from which is created a structure with Lippmann stratifications comprising a series of segments (15) evenly spaced along the path of an emitted light beam, and modulation means associated to each of said segments for injecting individually in each an excitation current carrying information data as electrical signals.

4. A laser emission device for carrying out the process according to claim 1 or 2, comprising means for modulating a laser beam (18) emitted in a light guide made of active photo-emissive material (12, 14), characterized in that said means include a series of distinct electrodes (1-6), evenly spaced along the path of said beam, each being electrically connected to receive an individualized modulation current, whereby a structure with Lippmann's stratification is created in said light guide .

5. A device according to claim 4 wherein said laser is a horizontal laser, in which said light guide in photo-emissive material is under the form of a ribbon (22), and wherein the pitch of said electrodes is less than a quarter of the shortest wavelength to be emitted by the laser.

6. A device according to claim 5, characterized in that said ribbon (22) shows a stratification of its emissive gain and/or refractive index with same segmentation pitch facing said electrodes (23).

7. A device according to claim 5 or 6, characterized in that the thickness of said ribbon (22) is less than said pitch of said electrodes (23).

8. A device according to claim 5 wherein said laser is vertical type laser, comprising a Bragg grating made of a stack (12) of layers (15) of photo-emissive material, characterized in that said modulation currents are applied separately to the electrodes (17) formed onto each of said layers.

9. A device according to claim 7, characterized in that each layer of the stack (12) has a thickness amounting at most to a quarter of the wavelength of the beam (18) emitted across the stack.

10. A laser receiver device for the implementation of the process according to claim 1 or 2, characterized in that it comprises a structure as in a laser emission device according to the claims 4 to 9 in which instead of the photo-emissive material a light-sensitive material is used so that the cumulative wavelength variations that reach said laser receiver device induce corresponding modulations through Lippmann effect into electrical signals received in a series of regularly spaced electrodes as in said laser emission device.
